(19) **Europäisches Patentamt European Patent Office Office européen des brevets**

(11) **EP 2 567 413 B1**

(12) **FASCICULE DE BREVET EUROPEEN**

(45) Date de publication et mention de la délivrance du brevet:
**06.08.2014 Bulletin 2014/32**

(51) Int Cl.:
**H01L 35/06** *(2006.01)*    **H01L 35/32** *(2006.01)*

(21) Numéro de dépôt: **11724262.8**

(22) Date de dépôt: **03.05.2011**

(86) Numéro de dépôt international:
**PCT/FR2011/000269**

(87) Numéro de publication internationale:
**WO 2011/138521 (10.11.2011 Gazette 2011/45)**

(54) **DISPOSITIF THERMOELECTRIQUE A VARIATION DE LA HAUTEUR EFFECTIVE DES PLOTS D'UN THERMOCOUPLE ET PROCEDE DE FABRICATION DU DISPOSITIF**

**THERMOELEKTROSCHE VORRICHTUNG ZUR VARIIERUNG DER EFFEKTIVEN HÖHE DER KONTAKTE EINES THERMOELEMENTS UND VERFAHREN ZUR HERSTELLUNG DER VORRICHTUNG**

**THERMOELECTRIC DEVICE WHICH PROVIDES FOR VARYING THE EFFECTIVE HEIGHT OF THE CONTACTS OF A THERMOCOUPLE, AND METHOD FOR MANUFACTURING THE DEVICE**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **05.05.2010 FR 1001930**

(43) Date de publication de la demande:
**13.03.2013 Bulletin 2013/11**

(73) Titulaire: **Commissariat à l'Énergie Atomique et aux Énergies Alternatives**
**75015 Paris (FR)**

(72) Inventeurs:
• **SAVELLI, Guillaume**
  **F-38000 Grenoble (FR)**
• **CORONEL, Philippe**
  **F-38530 Barraux (FR)**
• **PLISSONNIER, Marc**
  **F-38320 Eybens (FR)**

(74) Mandataire: **Talbot, Alexandre et al**
**Cabinet Hecké**
**Europole**
**10, rue d'Arménie - BP 1537**
**38025 Grenoble Cedex 1 (FR)**

(56) Documents cités:
**JP-A- 2007 035 974    JP-A- 2008 288 535**

**Description**

**Domaine technique de l'invention**

L'invention est relative à un dispositif thermoélectrique comprenant :

- un premier plot dans un premier matériau, ancré au niveau de sa première extrémité à un support,
- un second plot dans un second matériau, ancré au niveau de sa première extrémité audit support,
- un élément de connexion électrique muni de première et seconde zones de contact respectivement en contact électrique avec le premier plot et le second plot, de sorte à former un thermocouple.

**État de la technique**

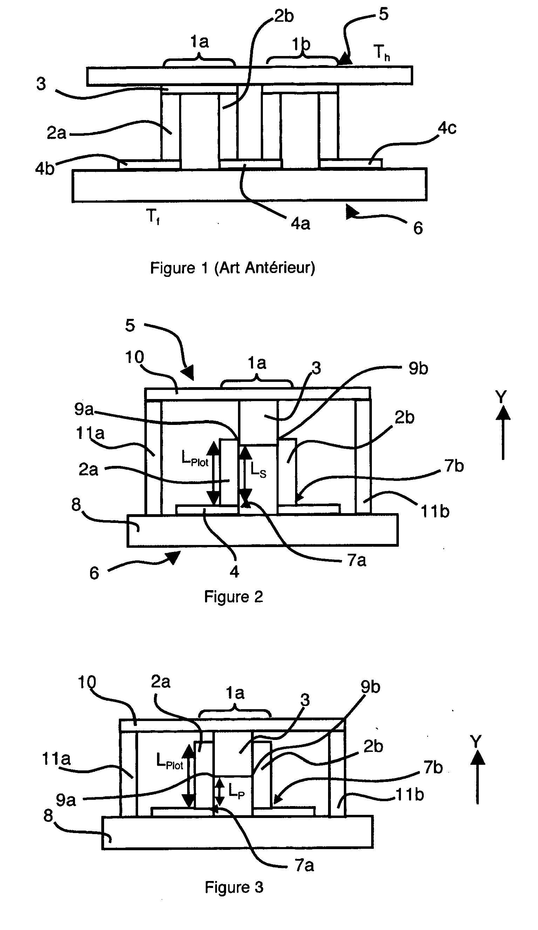

Une architecture classique d'un dispositif thermoélectrique à deux thermocouples 1 a, 1 b est illustrée à la figure 1. Chaque thermocouple 1 a, 1 b est formé par deux plots 2a, 2b reliés l'un à l'autre à l'une de leur extrémité par un élément de connexion électrique 3. Un premier plot 2a est, de préférence, formé dans un matériau de type P et un second plot 2b est, de préférence, formé dans un matériau de type N. Le dispositif peut comporter une pluralité de thermocouples 1 a, 1 b tels que décrits ci-dessus mis en série et reliés entre eux par des connecteurs 4a métalliques pour optimiser le rendement du dispositif. Des connecteurs métalliques 4b, 4c se trouvent aux extrémités de la série de thermocouples pour assurer les connexions électriques du dispositif.

Le dispositif thermoélectrique peut être utilisé soit en mode Seebeck, soit en mode Peltier. Il comporte un réservoir côté chaud 5 à température $T_h$ et un réservoir côté froid 6 à température $T_f$.

En mode Seebeck, le dispositif produit de l'énergie à partir d'un gradient de température entre le côté chaud 5 et le côté froid 6. Ce mode est aussi appelé mode générateur de puissance.

En mode Peltier, l'application d'un courant aux bornes du dispositif permet de générer un gradient de température entre le côté chaud 5 et le côté froid 6. Ce mode est aussi appelé mode refroidisseur.

En fait, le rendement du dispositif thermoélectrique dépend des matériaux utilisés, de la géométrie du module, et de l'environnement d'utilisation. Ainsi, un dispositif est soit optimisé pour le mode refroidisseur, soit utilisé pour le mode générateur de puissance, mais jamais pour les deux à la fois.

Le document JP-2008-288535-A décrit un module thermoélectrique comportant des thermocouples reliés électriquement en série et thermiquement en parallèle entre un côté froid et un côté chaud. Chaque thermocouple est formé à base de deux plots en matériaux différents, et disposé entre deux supports. Au niveau du côté chaud, les plots de chaque thermocouple comportent des encoches entre lesquelles sont disposés des moyens élastiques de rappel tel qu'un ressort de compression. Ces moyens de rappel sont isolés du support, et sont en contact avec deux éléments qui sont eux-mêmes en contact avec les plots. Les moyens élastiques de rappel permettent, selon une direction perpendiculaire aux plots, d'assurer un contact électrique stable et permanent entre les plots en cas de dilatation ou de stress thermique du module thermoélectrique.

**Objet de l'invention**

L'objet de l'invention vise à réaliser un dispositif qui puisse être optimisé à la fois pour le mode générateur de puissance et pour le mode refroidisseur.

On tend vers cet objectif par les revendications annexées et notamment par le fait que les moyens pour faire varier la position des zones de contact comprennent l'élément de connexion électrique, ledit élément de connexion étant mobile le long desdits premier et second plots.

L'invention est aussi relative à un procédé de fabrication d'un dispositif thermoélectrique comportant les étapes suivantes :

- former sur un substrat de support deux plots en matériau thermoélectrique électriquement isolés l'un de l'autre,
- former un élément mobile reliant électriquement les deux plots, et apte à se déplacer selon une direction perpendiculaire au substrat.

**Description sommaire des dessins**

D'autres avantages et caractéristiques ressortiront plus clairement de la description qui va suivre de modes particuliers de réalisation de l'invention donnés à titre d'exemples non limitatifs et représentés aux dessins annexés, dans lesquels :

La figure 1 illustre un dispositif selon l'art antérieur équipé de deux thermocouples reliés en série.

La figure 2 illustre un mode de réalisation d'un dispositif selon l'invention en position optimisée Seebeck.

La figure 3 illustre le dispositif de la figure 2 en position optimisée Peltier.

La figure 4 illustre la puissance générée par le dispositif en mode Seebeck en fonction de la hauteur des plots.

La figure 5 illustre la puissance générée par le dispositif en mode Peltier en fonction de la hauteur des plots.

Les figures 6 et 7 illustrent un perfectionnement du mode de réalisation des figures 2 et 3.

La figure 8 illustre un dispositif comportant trois thermocouples reliés en série.

Les figures 9 et 10 illustrent un autre mode de réalisation d'un dispositif thermoélectrique, respectivement en mode Seebeck et en mode Peltier.

Les figures 11 à 16 illustre une première partie d'étapes d'un procédé de fabrication d'un dispositif thermoélectrique.

Les figures 17 et 18 illustrent en trois dimensions un produit obtenu à la suite de la première partie d'étapes.

Les figures 19 à 22 illustrent la seconde partie d'étapes du procédé.

## Description de modes préférentiels de réalisation

Les modes de réalisations décrits ci-après permettent de modifier la hauteur effective des plots pour optimiser soit le mode générateur, soit le mode refroidisseur au sein d'un même thermocouple.

Selon un premier mode de réalisation illustré à la figure 2, le dispositif thermoélectrique comprend un premier plot 2a dans un premier matériau, et un second plot 2b dans un second matériau. Le premier plot 2a est ancré au niveau de sa première extrémité 7a à un support 8, et le second plot 2b est ancré au niveau de sa première extrémité 7b audit support 8. De préférence, un connecteur métallique 4 est interposé au niveau de chaque plot entre la première extrémité 7a, 7b correspondante et le support 8. Ces connecteurs permettent, par exemple, de relier en série, le cas échéant, plusieurs thermocouples du dispositif. Un élément de connexion électrique 3 relie les premier et second plots 2a, 2b de sorte à former un thermocouple 1 a. Cet élément de connexion électrique 3 est muni de première et seconde zones de contact 9a, 9b respectivement en contact électrique avec le premier plot 2a et le second plot 2b. Les plots 2a, 2b sont, de préférence, formés dans deux matériaux différents permettant de former un thermocouple. Ces plots 2a, 2b peuvent être formés dans un même matériau thermoélectrique, le premier plot étant dopé N et le second plot étant dopé P. Le matériau thermoélectrique peut aussi être un semi-métal comme le bismuth, l'antimoine, etc., ou un semiconducteur dégénéré comme le silicium, un alliage de silicium et de germanium, etc.

Le dispositif comprend en outre des moyens pour faire varier la position des première et seconde zone de contact 9a, 9b au niveau des premier et second plots 2a, 2b. Ceci permet en fait de faire varier la hauteur effective des plots en modulant la longueur du chemin électrique entre la première extrémité 7a, 7b de chaque plot 2a, 2b et la zone de contact 9a, 9b associée. Autrement dit, l'élément de connexion électrique 3 est apte à se déplacer de sorte à éloigner ou rapprocher les zones de contact 9a, 9b du support 8, c'est-à-dire selon l'axe Y sur la figure 2.

Sur la figure 2, le dispositif favorise le mode Seebeck, la hauteur effective des premier et second plots 2a, 2b est égale à $L_S$ qui correspond à la longueur du chemin électrique entre la première extrémité 7a, 7b d'un plot 2a, 2b et la zone de contact 9a, 9b associée audit plot de l'élément de connexion électrique 3. De préférence, la hauteur $L_S$ est inférieure ou égale à la hauteur réelle $L_{Plot}$ des plots 2a, 2b.

Sur la figure 3, le dispositif est optimisé en mode Peltier, ainsi la hauteur effective des premier et second plot 2a, 2b est définie par la longueur du chemin électrique entre la première extrémité 7a, 7b d'un plot 2a, 2b et la zone de contact 9a, 9b associée audit plot de l'élément de connexion électrique 3. Sur la figure 3, cette hauteur effective est égale à $L_P$, $L_P$ étant inférieure à $L_S$.

Sur les figures 2 et 3, la distance, entre la première extrémité 7a, 7b d'un plot 2a, 2b et la zone de contact 9a, 9b associée, est calculée à partir d'une partie de la zone de contact 9a, 9b qui est la plus proche de la première extrémité 7a, 7b.

Autrement dit, ces moyens pour faire varier la position des première et seconde zones de contact 9a, 9b au niveau des premier et second plots 2a, 2b permettent en fait de moduler la hauteur effective des premier et second plots 2a, 2b. Ainsi, le dispositif est capable de s'adapter à l'environnement extérieur, par exemple la température entre le côté chaud 5 et le côté froid 6, pour optimiser le mode de fonctionnement sélectionné.

À titre d'exemple, il est possible de caractériser un dispositif en tenant compte des paramètres définis ci-dessous dans la table I :

Table I

| Type | Paramètre | Variable | Valeurs |
|---|---|---|---|
| Paramètres thermiques | Température réservoir chaud | $T_h$ | 350K |
| | Température réservoir froid | $T_f$ | 300K |

(suite)

| Type | Paramètre | Variable | Valeurs |
|---|---|---|---|
| Paramètres matériaux | Coefficient Seebeck | S | 4,00E-04 V/K |
| | Conductivité thermique | $\lambda$ | 1,5W/m/K |
| | Résistivité électrique | $\rho$ | 1,60E-05$\Omega$.m |
| | Conductivité thermique matrice | $\lambda_{mat}$ | 0,026W/m/K |
| Paramètres géométriques | Nombre de plots | n | 4,20E+04 |
| | Écart plot-bord du dispositif | écart | 1,00E-04m |
| | Hauteur des plots | L | variable |
| | Côté plots | b | 8,00E-06m |
| | Surface des plots | $A_{np}$ | 6,40E-11m$^2$ |
| | Espace entre deux plots | d | 4,00E-05m |
| | Surface du dispositif | $A_{te}$ | 1,00E-04m$^2$ |
| Paramètres d'échanges thermiques | Surface de diffusion thermique | $A_{hs}$ | 2,00E-04m$^2$ |
| | Coefficient de transfert de chaleur | h | 1,00E+03W/m$^2$/K |
| Paramètres électriques | Résistance de contact | $R_c$ | 1,00E-11$\Omega$.m$^2$ |
| | Résistance interne du dispositif | $R_{int}$ | VAR en $\Omega$ |

Dans cette table, les paramètres thermiques définissent les températures aux bornes du dispositif (côté chaud $T_h$ et côté froid $T_f$ des thermocouples en Kelvin).

Les paramètres matériaux définissent les caractéristiques des matériaux utilisés pour former les plots comme le coefficient Seebeck, la conductivité thermique, la résistivité électrique, et aussi la conductivité thermique de la matrice qui correspond au matériau de remplissage entre les plots (dans l'exemple il s'agit d'air).

Les paramètres géométriques définissent le dispositif par le nombre de plots n (avec n/2 étant égal au nombre N de thermocouples), la hauteur L des plots, la section des plots $A_{np}$ définie dans le cas présent par un carré de côté b, l'espace d entre deux plots adjacents, la surface du dispositif $A_{te}$ sur laquelle sont répartis les plots, ainsi que la distance entre les plots les plus extérieurs et le bord du dispositif (l'écart bord-plot nécessaire pour des considérations de réalisation technologique).

Les paramètres d'échange thermique sont la surface d'échange $A_{hs}$ et le coefficient de transfert h entre le dispositif et l'environnement (côté froid).

Les paramètres électriques définissent la résistance électrique de contact $R_c$ correspondant à la résistance électrique entre un plot et son élément de connexion et la résistance interne $R_{int}$ correspondant à la résistance interne du dispositif mesurée aux bornes de la série de thermocouples comprenant les résistances de contact et les résistances électriques des plots.

Avec de tels paramètres, la puissance électrique en mode Seebeck, et la puissance en refroidissement du mode Peltier peuvent s'écrire sous la forme d'équations. Les équations qui vont suivre sont basées sur un modèle prenant en compte les paramètres intervenants d'un point de vue électrique et thermique, ainsi que les paramètres liés à l'environnement dans lequel sera introduit le dispositif. En effet, la température disponible pour une utilisation du côté froid est à une température $T_f$, ne correspondant pas réellement à la température froide du thermocouple, qui est en fait à une température $T_c$ supérieure à la température $T_f$. C'est donc la différence de température du dispositif $T_h$-$T_c$ qui est prise en compte dans les équations et non la différence de température de l'environnement $T_h$-$T_f$.

Dans l'exemple et selon les caractéristiques de la table I, les côtés chaud $T_h$ et froid $T_f$ sont respectivement à des températures de 350 Kelvin et 300 Kelvin. La surface du module $A_{te}$ est imposée à 1cm$^2$ sur laquelle sont répartis 42000 plots, soit 21000 thermocouples, chaque plot ayant une section en forme de carré de 8x8$\mu$m$^2$. Enfin les paramètres liés à l'échangeur thermique ont une surface $A_{hs}$ de 2cm$^2$ et un coefficient de transfert de chaleur h de 1000W.m$^{-2}$.K$^{-1}$.

Ainsi, la puissance électrique $Q_{gen}$ en mode Seebeck peut s'exprimer selon l'équation :

$$Q_{gen} = \frac{N^2 \times S^2 \times (T_h - T_c(L))^2}{4R_{int}^2(L) \times A_{hs}} \quad (1)$$

Dans l'équation (1), $T_c$ est une inconnue et dépend de L, tout comme la résistance interne $R_{int}$, et N représente le nombre de thermocouples (N=n/2).

$R_{int}$ peut être définie selon l'équation :

$$R_{int}(L) = 2N \times \left( \frac{\rho \times L}{A_{np}} + \frac{2R_c}{A_{np}} \right) \quad (2)$$

Pour connaître l'expression de $T_c$, il faut écrire l'équation présentant le bilan des puissances entrant au niveau du dispositif thermoélectrique avec la chaleur quittant le côté froid soit :

$$P_{Seeb} + P_{cond} + P_j = P_{hs} \quad (3)$$

où $P_{Seeb}$ représente l'effet Seebeck, $P_{cond}$ représente le transfert de chaleur par conduction, $P_j$ les pertes par effet Joules et $P_{hs}$ le transfert de chaleur par convection. Ces quatre termes font intervenir $T_c$, et aboutissent à la résolution de l'équation :

$$\left( \frac{2N \times \lambda \times \Delta T \times A_{np}}{L} + \frac{\lambda_{air} \times \Delta T \times (A_{te} - 2NA_{np})}{L} \right) + N \times S \times T_c \times I + \frac{1}{2}R_{int} \times I^2 = (T_c - T_f)hA_{hs}$$

$$(4)$$

où $\Delta T$ représente la différence de température entre $T_h$ et $T_c$, $\lambda_{air}$ la conductivité thermique de l'air et I le courant traversant les thermocouples.

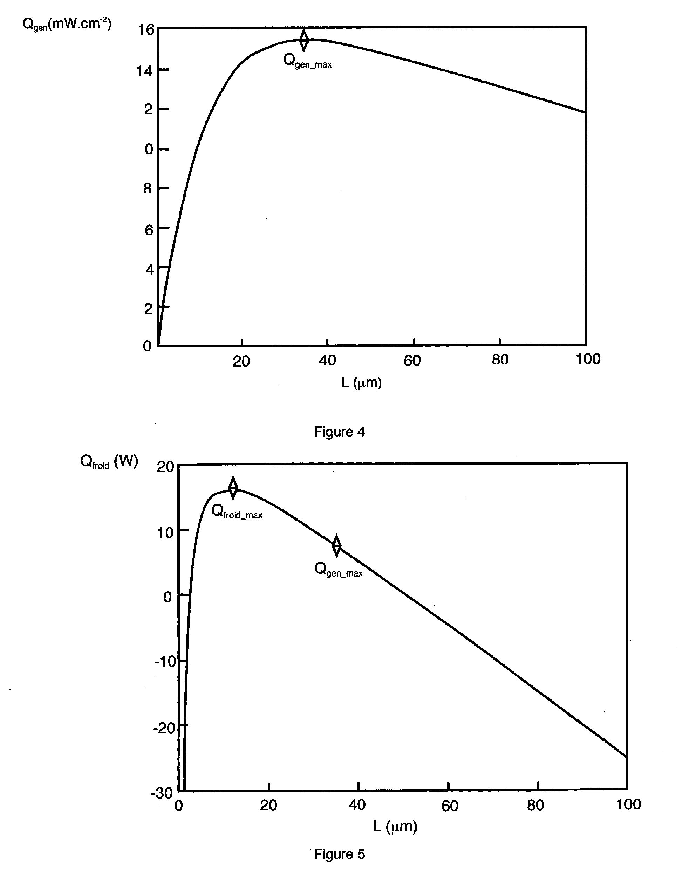

Cette équation 4 montre que $T_c$ est aussi fonction du paramètre L. Ainsi les équations (1) et (4) démontrent la dépendance de $Q_{gen}$ en fonction de la hauteur L des plots. Selon les variables fixées dans la table I, la figure 4 illustre l'évolution de $Q_{gen}$ en fonction de la hauteur effective des plots. Sur cette figure, il est possible d'observer un point $Q_{gen\_max}$ de 15,4mW.cm$^{-2}$ pour une hauteur de plot de 35$\mu$m.

Cette valeur $L_{Seeb}$ peut aussi être obtenue analytiquement en résolvant l'équation :

$$\left( \frac{\partial(Q_{gen})_{max}}{\partial L} \right)_{L=L_{Seeb}} = 0 = \left( \frac{\partial \left( \frac{N^2 \times S^2 \times (T_h - T_c(L))^2}{4 \times (R_{int}(L))^2 \times A_{hs}} \right)}{\partial L} \right)_{L=L_{Seeb}} \quad (5)$$

Des tests ont aussi été effectués pour le mode Peltier. En prenant en compte les effets Peltier, Joule et la conduction thermique, la puissance en froid d'un dispositif thermoélectrique favorisant l'effet Peltier peut s'écrire sous la forme :

$$Q_{froid} = N \times S \times I \times T_c(L) - \frac{1}{2}R_{int}(L) \times I(L)^2 - K(L) \times (T_h - T_c(L)) \quad (6)$$

Cette équation 6 fait aussi intervenir la variable L représentative de la hauteur des plots, I le courant traversant la série de thermocouples, et où K(L) représente la conductance thermique totale définie par :

$$K(L) = \frac{2N \times \lambda \times A_{np}}{L} + \frac{\lambda_{air} \times (A_{te} - 2N \times A_{np})}{L} \quad (7)$$

En application des équations (6) et (7), la figure 5 représente l'évolution de $Q_{froid}$ en fonction de la hauteur L des plots. Dans le cas présent, les paramètres d'entrée sont différents du mode Seebeck. Ainsi, un courant d'entrée égal à 10mA traverse la série de thermocouples.

Dans ces conditions, si la hauteur des plots était égale à celle déterminée précédemment pour le mode Seebeck, une puissance $Q_{froid}$ de 7,6W serait obtenue. La lecture de la courbe de la figure 5 montre que cette valeur de 7,6W est loin d'être optimale. En effet, la figure 5 montre bien qu'une hauteur moins élevée de plots permet d'obtenir une puissance $Q_{froid\_max}$ optimale de 16,2W. Cette hauteur de plots optimisée Peltier est de 11 $\mu$m, elle est en effet bien plus faible que celle nécessaire pour optimiser un même dispositif thermoélectrique pour l'effet Seebeck.

Cette démonstration valide donc les avantages particuliers que présente le dispositif dont le thermocouple comporte des plots à hauteur effective variable, et le gain qu'il peut apporter en étant sélectivement optimisé pour le mode Seebeck, ou pour le mode Peltier.

Selon un exemple particulier de réalisation, les moyens pour faire varier la position des première et seconde zones 9a, 9b comprennent l'élément de connexion électrique 3. L'élément de connexion 3 est alors mobile le long desdits plots 2a, 2b. Dans cet exemple de réalisation, c'est donc la mobilité de l'élément de connexion 3 qui permet de moduler la hauteur effective des plots 2a, 2b comme représenté aux figures 2 et 3.

Sur les exemples de réalisation des figures 2 et 3, l'élément de connexion 3 mobile peut être porté par une membrane 10 dont la déformation permet un coulissement de l'élément de connexion 3 le long des premier et second plots 2a, 2b. La membrane 10 peut être reliée au support 8 par au moins un pilier 11 a, 11 b (sur les figures 2 et 3, le dispositif comporte deux piliers disposés de part et d'autre des plots 2a, 2b). Bien entendu, il ne s'agit que d'un exemple particulier de réalisation, l'homme du métier pouvant adapter le fonctionnement de la membrane par tout autre type de moyens permettant, par exemple, à l'élément de connexion 3 de coulisser entre les plots 2a, 2b selon la direction longitudinale desdits plots, c'est-à-dire selon l'axe Y sur les figures 2 et 3.

Lorsque le thermocouple 1 a est en fonctionnement, le contact électrique entre l'élément de connexion 3 et les premier et second plots 2a, 2b est assuré que cela soit en position haute, ou en position basse (mode Seebeck ou Peltier). Dans certains cas, les erreurs de conception lors de la réalisation du dispositif ne permettent pas d'assurer une équidistance parfaite entre les premier et second plots 2a, 2b, ceci peut alors induire un certain jeu fonctionnel entre l'élément de connexion 3 et les premier et second plots 2a, 2b. Ce jeu fonctionnel provoque une perte de contact électrique entre l'élément de connexion 3 et les premier et second plots 2a, 2b du thermocouple, qui devient alors inutilisable. De la même manière, une erreur de conception qui induirait un rapprochement localisé des premier et second plots 2a, 2b risquerait d'endommager le thermocouple lors du coulissement de l'élément de connexion 3 électrique pour passer de la position Seebeck à la position Peltier, ou inversement.

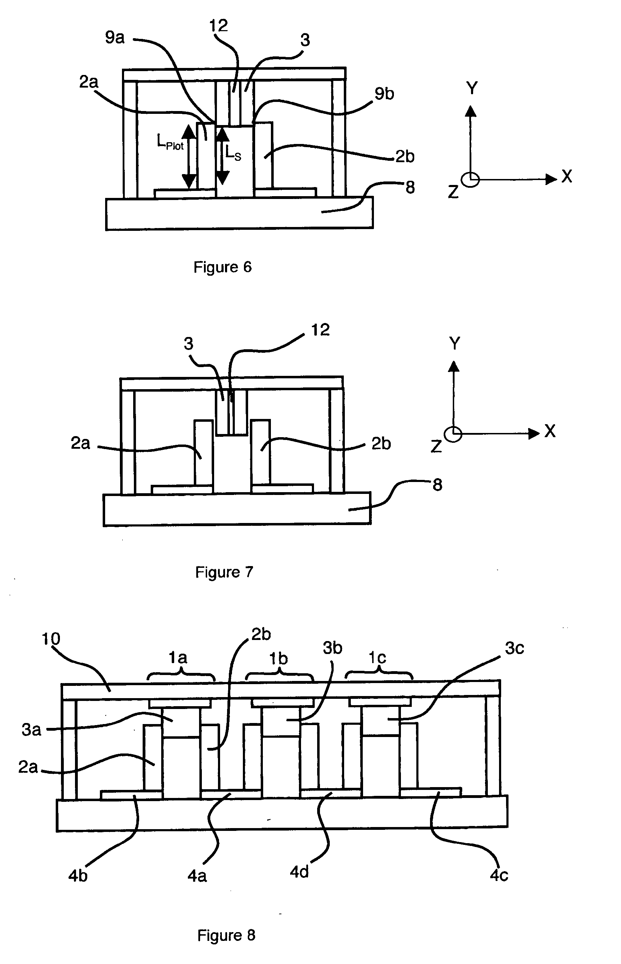

Ainsi, l'élément de connexion 3 peut comporter des moyens pour faire varier son épaisseur dans une direction (selon l'axe X aux figures 6 et 7) perpendiculaire à sa direction de coulissement (selon l'axe Y sur les figures 6 et 7) et située dans un plan parallèle au plan des premier et second plots 2a, 2b. Les moyens pour faire varier l'épaisseur de l'élément de connexion 3 peuvent comporter un matériau 12 apte à changer de volume sous l'action d'une stimulation, par exemple un changement de température, ou l'application d'une tension prédéterminée. Bien entendu, le changement de volume est réversible pour permettre le contact électrique entre les plots 2a, 2b et l'élément de connexion 3 lorsque le matériau 12 est dilaté, et pour permettre à l'élément de connexion 3 de coulisser lorsque le matériau 12 est rétracté. À titre d'exemple, il peut être utilisé du Nafion®, du Lipon®, ou du polypyrroles sous certaines conditions. Les stimulations peuvent être électriques, thermiques ou optiques.

Le matériau 12 apte à changer de volume est, par exemple, une tranche en matériau à changement de volume formée dans l'élément de connexion 3 électrique, ladite tranche étant, de préférence, dans un plan parallèle au plan comportant la direction de coulissement et perpendiculaire au plan des premier et second plots 2a, 2b. Sur la figure 6, l'élément de connexion 3 électrique est en position haute optimisée Seebeck, et les zones de contact 9a, 9b de l'élément de connexion 3 électrique sont respectivement en contact avec les premier et second plots 2a, 2b. Sur la figure 7, la stimulation est appliquée si bien que le matériau apte à changer de volume se rétracte de sorte à créer un jeu fonctionnel suffisant, entre l'élément de connexion 3 et les deux plots 2a, 2b, pour permettre à l'élément de connexion 3 de coulisser entre les plots 2a, 2b sans endommager ces derniers. Ainsi, l'élément de connexion 3 électrique peut être abaissé en direction du support 8 jusqu'à la position optimisée Peltier, puis le matériau apte à changer de volume se dilate, par exemple grâce à une nouvelle stimulation, de sorte à ce que les zones de contact 9a, 9b de l'élément de connexion électrique 3 viennent assurer le lien électrique au niveau des plots 2a, 2b.

Le dispositif peut aussi comporter plusieurs thermocouples reliés entre eux en série. Un tel dispositif est illustré à la figure 8, la membrane 10 suspendue au-dessus des plots 2a, 2b comporte alors une pluralité d'éléments de connexion 3a, 3b, 3c électrique, électriquement isolés les un des autres. Sur la figure 8, trois thermocouples 1 a, 1b, 1c sont reliés en série au niveau du support 8 par des connecteurs 4a, 4b, 4c, 4d en contact avec la première extrémité de chaque plot.

Les différents modes de réalisation ne sont pas limités à une membrane déformable comportant les éléments de connexion 3 électrique sur une face orientée vers le support 8. Ainsi, il est possible d'utiliser tout type de moyens permettant un déplacement d'un élément de connexion électrique le long des plots, par exemple un rail apte à se déplacer selon l'axe Z et/ou X et/ou Y.

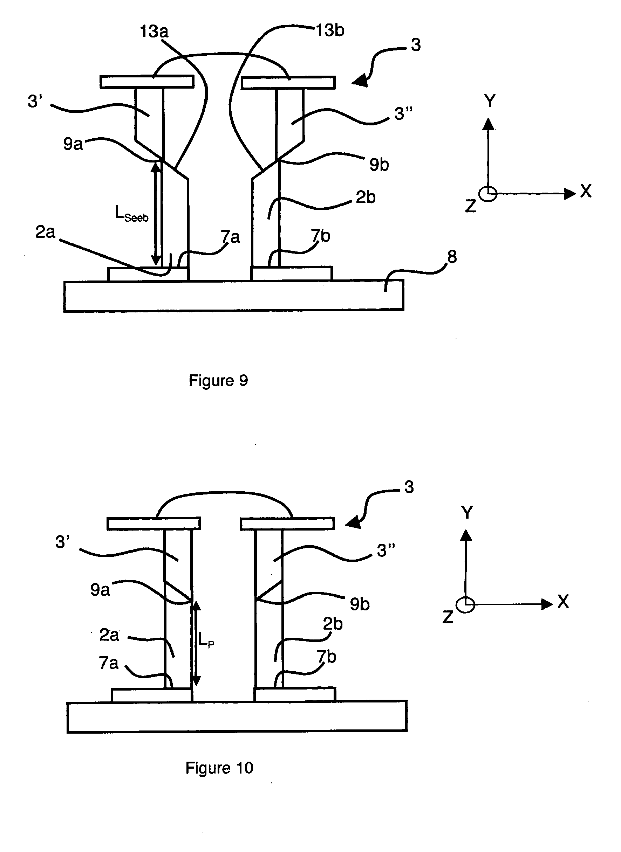

Selon un exemple de réalisation illustré aux figures 9 et 10, l'élément de connexion 3 est mobile, et comporte deux éléments 3', 3" de contact déplaçable indépendamment l'un de l'autre. Il est ainsi possible d'optimiser chaque plot 2a, 2b individuellement.

À titre d'exemple, la seconde extrémité de chaque plot 2a, 2b est en forme de biseau 13a, 13b, et la zone de contact 9a, 9b associée de l'élément de connexion 3 a une forme de biseau complémentaire. Il est alors possible de modifier la hauteur effective des plots 2a, 2b en modifiant la position des zones de contact 9a, 9b par rapport aux plots 2a, 2b. Sur la figure 9, le dispositif comporte un thermocouple dont l'élément de connexion 3 électrique comprend deux éléments de contact 3', 3" chacun munis d'une zone de contact 9a, 9b en position Seebeck. Sur la figure 10, le même dispositif est en position Peltier, les éléments de contact 3', 3" ont subi un déplacement vers le support 8, c'est-à-dire selon l'axe X et l'axe Y. La hauteur effective $L_P$ est alors définie par la distance séparant la première extrémité du plot 7a et la partie la plus proche (9a, 9b) de l'élément de contact 3', 3" associé.

Dans les exemples donnés ci-dessus, c'est la partie haute du dispositif qui se déplace, c'est-à-dire l'élément de connexion et la membrane associée. Bien entendu, il est aussi possible de réaliser le même type de dispositif en fixant l'élément de connexion et en rendant mobile les plots d'un même thermocouple.

Selon un autre exemple (non représenté), il est aussi possible de former les plots sur une face d'un premier support, puis de former sur une face d'un second support, destinée à venir en regard de la face du premier support, un élément de connexion électrique muni de première et seconde zones de contact destinées à venir respectivement en contact électrique avec le premier plot et le second plot. Il suffit alors de prévoir des moyens pour faire varier la distance entre la face du premier support portant les plots et la face du second support portant l'élément de connexion électrique.

Le procédé de fabrication d'un dispositif thermoélectrique tel que défini ci-dessus comporte au moins les étapes suivantes:

- former sur un substrat de support deux plots en matériau thermoélectrique électriquement isolés l'un de l'autre,
- former un élément mobile reliant électriquement les deux plots, et apte à se déplacer selon une direction perpendiculaire au substrat.

En fait, l'élément de connexion mobile peut être formé après les plots, à partir d'une couche d'encapsulation, de préférence réalisée en matériau sacrificiel. Cette couche d'encapsulation permet de former un moule délimitant au moins partiellement l'élément mobile.

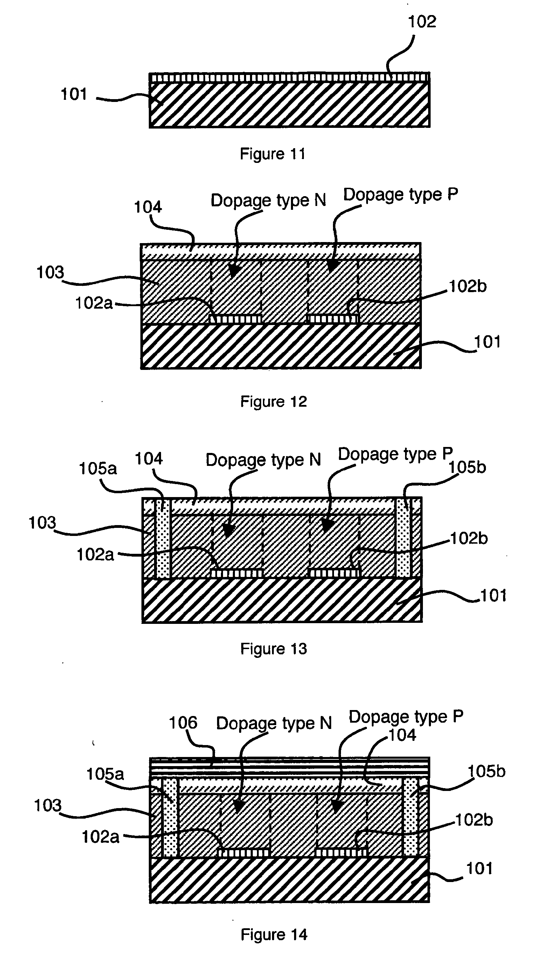

A titre d'exemple particulier illustré à partir de la figure 11, le procédé peut comporter, sur un substrat de support 101, la formation de connecteurs électriques 102a, 102b au niveau de chaque futur plot du thermocouple. Sur les figures 11 et 12, les connecteurs 102a, 102b sont, par exemple, formés par le dépôt d'une couche électriquement conductrice 102 (figure 11), qui est ensuite structurée de sorte à délimiter les connecteurs électriques 102a, 102b (figure 12). Ensuite une couche 103 dans un matériau, de préférence thermoélectrique, est déposée au-dessus des connecteurs 102a, 102b, puis est recouverte d'une première couche sacrificielle 104, par exemple une couche de diélectrique d'un premier type (figure 12). Le matériau thermoélectrique peut être choisi parmi ceux listés précédemment. La couche en matériau thermoélectrique 103 peut être, après son dépôt, dopée localement, par exemple par implantation ionique, pour former au niveau de chaque futur thermocouple un plot dopé type N et un plot dopé type P.

Au moins un pilier de support 105a, 105b de membrane peut ensuite être structuré (figure 13). Ce pilier peut avoir une forme circulaire au centre de laquelle sont disposés les connecteurs 102a, 102b, ou être un simple pilier longitudinal perpendiculaire au substrat 101, destiné à supporter la membrane à une de ses extrémités. Sur la figure 13 deux piliers 105a, 105b de support de membrane sont structurés de part et d'autre des connecteurs électriques 102a, 102b. À titre d'exemple, le ou les piliers 105a, 105b peuvent être réalisés par structuration de la couche thermoélectrique 103 et de la première couche sacrificielle 104, par exemple par des étapes de lithographie et de gravure pour former au moins une zone vide (deux dans le cas où la membrane est supportée par deux piliers) dont le fond est délimité par le substrat de support 101. Chaque zone vide est ensuite comblée par le dépôt d'un matériau destiné à former les piliers 105a, 105b, avantageusement le matériau utilisé pourra être conducteur comme le Cu, Al, TiN, ou tout métal standard utilisé en microélectronique et comptatible avec les techniques de dépôt de type CVD ou PVD. La formation des piliers 105a, 105b est, de préférence, suivie d'une planarisation mécano-chimique jusqu'à la première couche sacrificielle 104, de sorte à former une surface sensiblement plane au niveau de laquelle affleurent la première couche sacrificielle 104 et le sommet des piliers 105a, 105b.

Selon une variante non représentée, il est aussi possible de former les piliers en premier lieu sur le substrat de support 101, c'est-à-dire avant le dépôt de la couche électriquement conductrice 102, de la couche thermoélectrique 103 et de la première couche sacrificielle 104.

Après la formation des piliers 105a, 105b, une deuxième couche sacrificielle 106 est déposée sur la première couche sacrificielle 104 comme illustré à la figure 14. De préférence, la deuxième couche sacrificielle 106 est d'un matériau différent de celui de la première couche sacrificielle 104 pour permettre de graver sélectivement les différentes couches.

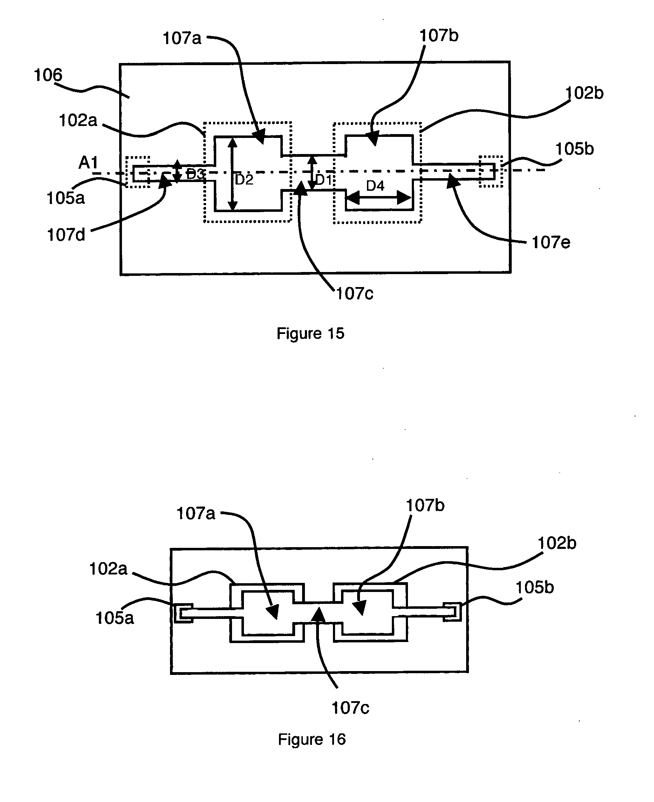

Ensuite, la deuxième couche sacrificielle 106 est structurée selon un motif. La figure 15 illustre une vue de dessus de l'empilement, la première couche visible est donc la deuxième couche sacrificielle 106. Sur cette deuxième couche sacrificielle 106, le motif présente un axe longitudinal A1 qui passe par les deux piliers 105a, 105b. Ce motif peut se présenter sous la forme d'une poutre comportant deux zones 107a, 107b, disposées au-dessus des connecteurs électriques 102a, 102b. Ces deux zones 107a, 107b sont reliées entre elles par une portion centrale 107c de la poutre. La poutre comporte en outre une portion latérale 107d reliée à l'une des zones 107a et passant au-dessus d'un des piliers 105a. Une autre portion latérale 107e est reliée à l'autre zone 107b, et passe au-dessus de l'autre pilier 105b.

Cette structuration selon le motif qui comprend les dessins des deux zones 107a, 107b, de la portion centrale 107c et des portions latérales 107d, 107e, permet ensuite une gravure sélective, par exemple par gravure par plasma anisotrope en se servant de la structuration de la deuxième couche sacrificielle 106 comme masque dur, de la première couche sacrificielle 104 et de la couche en matériau thermoélectrique 103 jusqu'au substrat de support 101 ou des connecteurs 102a, 102b. La figure 16 illustre une vue de dessus de l'empilement après la gravure anisotrope où l'on remarque que les piliers et les connecteurs 102a, 102b ont été libérés.

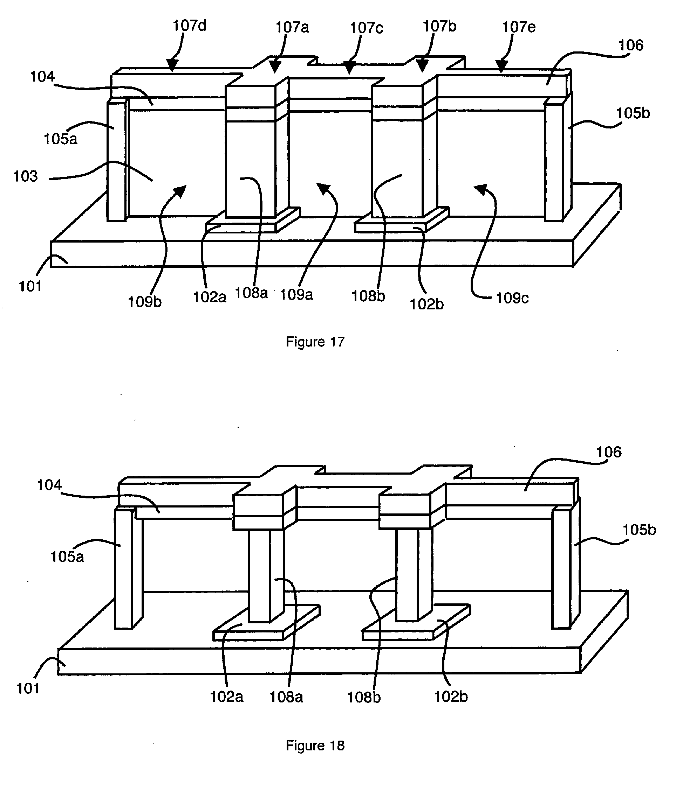

Comme illustré en vue tridimensionnelle à la figure 17, les futurs plots 108a, 108b sont à la fois reliés entre eux par une première paroi 109a, au niveau de la portion centrale 107c, et sont respectivement reliés aux piliers 105a, 105b par une deuxième et une troisième paroi 109b, 109c au niveau de la portion latérale associée 107d, 107e. Les plots 108a, 108b peuvent être libérés par tout type de méthode connue par l'homme du métier, par exemple par implantation ionique puis par gravure.

Sur l'exemple particulier des figures 15 à 18, le motif 107a, 107b, 107c, 107d, 107e est structuré de sorte à faciliter la formation et la libération des plots 108a, 108b par gravure isotrope. Ainsi, après la gravure anisotrope selon le motif 107a, 107b, 107c, 107d, 107e, les plots 108a, 108b sont reliés entre eux par la première paroi 109a, le plot 108a est relié au pilier 105a par la deuxième paroi 109b, et le plot 108b est relié au pilier 105b par la troisième paroi 109c (figure 17). La gravure isotrope de la couche thermoélectrique 103 permet de supprimer les parois 109a, 109b, 109c (figure 18). Dans cet exemple, les portions latérales 107d, 107e, la portion centrale 107c et les zones 107a, 107b ont respectivement des largeurs D3, D1 et D2 (figure 15), perpendiculaires à l'axe longitudinal A1 passant par les deux piliers 105a, 105. Les dimensions D1 et D3 sont, de préférence, identiques, et la dimension D2 des zones 107a, 107b est supérieure à la plus grande dimension entre D1 et D3. De même, la dimension D4 des zones 107a, 107b, selon l'axe longitudinal A1, est supérieure à la plus grande dimension entre D1 et D3. Ces contraintes permettent alors, après la gravure anisotrope du motif, de libérer les plots 108a, 108b comme illustré à la figure 18 par gravure isotrope de la couche thermoélectrique 103, les plots se retrouvant alors amincis. Autrement dit, de manière générale, les plots peuvent être formés par le dépôt d'une couche en matériau thermoélectrique 103 sur le substrat de support 101, suivi par la formation d'un motif de gravure ayant une direction longitudinale et comportant deux zones 107a, 107b reliées par une portion centrale 107c, les dimensions transversales et longitudinales des zones 107a, 107b étant supérieures à la dimension transversale de la portion centrale 107c. Ensuite, la couche en matériau thermoélectrique 103 est gravée au moyen du motif de gravure, et enfin la couche en matériau thermoélectrique 103 est gravée partiellement de manière isotrope pour libérer les plots 108a, 108b.

Après libération des plots 108a, 108b, le tout est, de préférence, noyé dans une troisième couche sacrificielle 110 formant la couche d'encapsulation précédemment évoquée. Cette troisième couche sacrificielle 110 est, de préférence, formée dans un matériau différent de la première et de la seconde couche sacrificielle 104, 106. Comme indiqué précédemment, le choix de matériaux différents permettra par la suite de graver sélectivement les différentes couches sacrificielles. La troisième couche sacrificielle 110 est ensuite aplanie pour former une surface plane avec la deuxième couche sacrificielle 106, par exemple par CMP, ou CMP suivi d'une gravure.

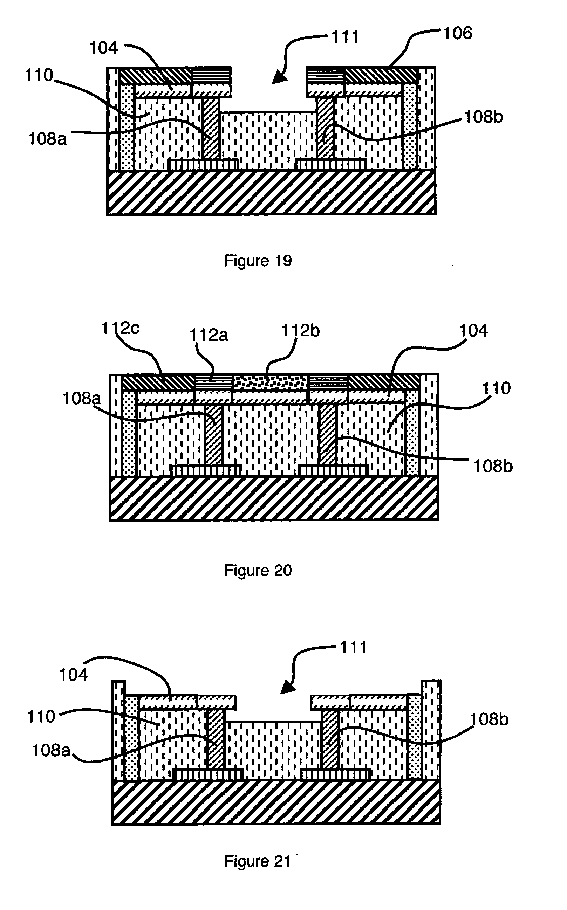

Ensuite, il est possible de former comme illustré à la figure 19, qui est une vue en coupe de l'empilement, une cavité 111 ouverte dans l'empilement en gravant sélectivement, selon le dessin de la portion centrale 107c, la seconde couche sacrificielle 106, la première couche sacrificielle 104, et une partie de la troisième couche sacrificielle 110. De préférence, la troisième couche sacrificielle 110 est gravée de manière isotrope jusqu'à affleurement de flancs latéraux des premier et second plots 108a, 108b dans la cavité 111. Ensuite, la cavité 111 peut être comblée par un matériau électriquement conducteur qui formera à la fois une partie de l'élément de connexion et de la membrane. Enfin, la première couche sacrificielle 104 et la troisième couche sacrificielle 110 peuvent être retirées, la membrane étant alors en partie formée par la deuxième couche sacrificielle 106 qui n'est pas totalement retirée.

Autrement dit, le motif 107a, 107b, 107c, 107d, 107e de gravure peut être formé par une première couche sacrificielle 104 inférieure et une deuxième couche sacrificielle 106 supérieure. La couche d'encapsulation, formée dans le cas présent par la troisième couche sacrificielle 110, forme une surface plane commune avec la deuxième couche sacrificielle 106. Ensuite, la cavité 111 est formée par élimination du motif de gravure au niveau de la portion centrale 107c jusqu'à la couche d'encapsulation, et par retrait d'une partie de la couche d'encapsulation au moins sous une partie de la portion centrale 107c.

Selon un mode de réalisation préféré illustré aux figures 19 et 20, après aplanissement de la troisième couche sacrificielle 110, la deuxième couche sacrificielle 106 est éliminée sélectivement jusqu'à la première couche sacrificielle 104. Cette étape (non représentée) permet de délimiter une cavité ouverte dont la forme générale reprend celle du motif défini précédemment. Autrement dit, la cavité a une forme délimitée par les deux zones 107a, 107b, la portion centrale 107c et les portions latérales 107d, 107e. Sur la figure 20, les deux zones 107a, 107b, la portion centrale 107c et les portions latérales 107d, 107e sont, de préférence, respectivement comblées par des premier, deuxième et troisième matériaux 112a, 112b, 112c.

L'exemple suivant donne une méthode pouvant être utilisée pour remplir les zones 107a, 107b et portions 107c, 107d, 107e de matériaux différents. Dans l'exemple, la dimension D1 de la portion centrale 107c est supérieure à deux fois la dimension D3 des portions latérales 107e, 107d, et la dimension D2 des zones 107a, 107b ainsi que la dimension D4 des zones 107a, 107b sont supérieures à deux fois la dimension définie par la largeur D1 (figure 15). Ceci permet dans une première étape de remplir les portions latérales 107d, 107e en déposant par dépôt conforme une couche en troisième matériau 112c d'épaisseur équivalente à la moitié de D3, et de retirer le troisième matériau 112c au niveau des zones 107a, 107b et de la portion centrale 107c sur une épaisseur égale à la moitié de D3, sans retirer le troisième matériau 112c des portions latérales 107d, 107e. Puis dans une seconde étape la portion centrale 107c est remplie en déposant, par dépôt conforme, une couche en deuxième matériau 112b d'épaisseur équivalente à la moitié de D1. Le deuxième matériau 112b est ensuite retiré au niveau des zones 107a, 107b, sur une épaisseur égale à la moitié de D1 sans retirer le second matériau 112b de la portion centrale 107c. Enfin, les zones 107a, 107b peuvent être comblées avec le premier matériau 112a.

La figure 19 illustre l'étape suivante au cours de laquelle une cavité 111 est formée par retrait du deuxième matériau 112b, de la première couche sacrificielle 104 au niveau de la portion centrale 107c, et d'une partie de la troisième couche sacrificielle 110 jusqu'à affleurement de flancs latéraux des premier et second plots 108a, 108b dans la cavité 111. De préférence, le retrait de la partie de la troisième couche sacrificielle 110 est réalisé par gravure isotrope pour permettre aux plots d'affleurer dans la cavité 111.

Sur la figure 21, les premier et troisième matériaux 112a, 112b sont sélectivement éliminés jusqu'à affleurement du reste de la première couche sacrificielle 104.

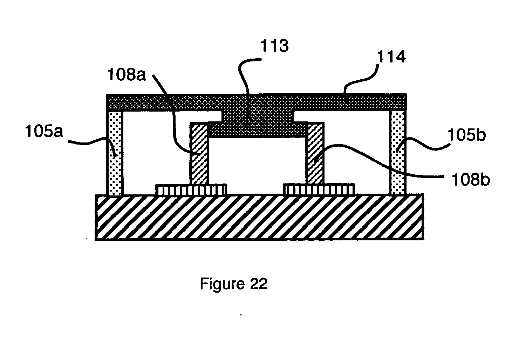

La dernière étape illustrée à la figure 22 consiste à former l'élément de connexion 113 entre les deux plots 108a, 108b, ledit élément de connexion 113 étant en contact avec lesdits plots 108a, 108b, et à former la membrane 114 portant ledit élément de connexion 113. La membrane 114 est ancrée aux sommets des piliers de support 105a, 105b. Pour finir, le reste des première et troisième couches sacrificielles 104, 110 est retiré sélectivement.

Selon une variante, les premier et troisième matériaux ne sont pas éliminés, et la cavité 111 est directement comblée par un matériau électriquement conducteur. La membrane 114 est alors formée par les premier et troisième matériaux et le matériau remplissant la cavité. Enfin, le reste des première et troisième couches sacrificielles 104, 110 est retiré sélectivement. Pour obtenir le dispositif final.

Selon un développement, le dispositif thermoélectrique comporte la formation de plusieurs thermocouples comme décrit précédemment. La membrane et les éléments de connexion sont alors formés en deux temps avec interposition d'une couche électriquement isolante entre chaque élément et la membrane de sorte à éviter le court-circuit des thermocouples.

Selon une variante non représentée, après la formation de l'élément de connexion, un trou est formé dans ce dernier en direction du substrat de support. Ce trou est ensuite comblé par un matériau à changement de volume pour former les moyens pour faire varier l'épaisseur de l'élément de connexion.

## Revendications

1. Dispositif thermoélectrique comprenant :

    - un premier plot (2a) dans un premier matériau, ancré au niveau de sa première extrémité (7a) à un support (8),
    - un second plot (2b) dans un second matériau, ancré au niveau de sa première extrémité (7b) audit support (8),
    - un élément de connexion électrique (3) muni de première et seconde zones de contact (9a, 9b) respectivement en contact électrique avec le premier plot (2a) et le second plot (2b), de sorte à former un thermocouple (1 a),
    - des moyens pour faire varier la position des première et seconde zones de contact (9a, 9b) au niveau des premier et second plots (2a, 2b).

dispositif **caractérisé en ce que** les moyens pour faire varier la position des zones de contact (9a, 9b) comprennent l'élément de connexion électrique (3), ledit élément de connexion (3) étant mobile le long desdits premier et second plots (2a, 2b).

2. Dispositif selon la revendication 1, **caractérisé en ce que** l'élément de connexion mobile (3) est porté par une membrane (10) dont la déformation permet un coulissement de l'élément de connexion (3) le long des premier et second plots (2a, 2b).

3. Dispositif selon la revendication 2, **caractérisé en ce que** l'élément de connexion (3) comprend des moyens pour faire varier son épaisseur dans une direction perpendiculaire à sa direction de coulissement et située dans un plan parallèle au plan des premier et second plots (2a, 2b).

4. Dispositif selon la revendication 3, **caractérisé en ce que** les moyens pour faire varier l'épaisseur de l'élément de connexion (3) comprennent un matériau (12) apte à changer de volume sous l'action d'une stimulation.

5. Procédé de fabrication d'un dispositif thermoélectrique comprenant les étapes suivantes :

   - former sur un substrat de support (101) deux plots (108a, 108b) en matériau thermoélectrique électriquement isolés l'un de l'autre, procédé **caractérisé en ce que** former un element mobile (113) reliant électriquement les deux plots et apte à se déplacer selon une direction perpendiculaire au substrat (101).

6. Procédé selon la revendication 5, **caractérisé en ce qu'**après formation des plots (108a, 108b), une couche d'encapsulation (110) est déposée pour former un moule délimitant au moins partiellement l'élément mobile (113).

7. Procédé selon l'une des revendications 5 et 6, **caractérisé en ce que** les plots sont formés par les étapes suivantes :

   - déposer une couche en matériau thermoélectrique (103),
   - former un motif de gravure ayant une direction longitudinale et comportant deux zones (107a, 107b) reliées par une portion centrale (107c), les dimensions transversales et longitudinales des zones (107a, 107b) étant supérieures à la dimension transversale de la portion centrale (1 07c),
   - graver la couche en matériau thermoélectrique (103) au moyen du motif de gravure,
   - graver partiellement de manière isotrope la couche en matériau thermoélectrique (103) pour libérer les plots (108a, 108b).

8. Procédé selon les revendications 6 et 7, **caractérisé en ce que** le motif de gravure étant formé par une première couche sacrificielle (104) inférieure et une deuxième couche sacrificielle (106) supérieure, la couche d'encapsulation (110) forme une surface plane commune avec la deuxième couche sacrificielle (106), et la cavité (111) est formée par élimination du motif de gravure au niveau de la portion centrale (107c) jusqu'à la couche d'encapsulation (110), et par retrait d'une partie de la couche d'encapsulation au moins sous une partie de la portion centrale (107c).

**Patentansprüche**

1. Thermoelektrische Vorrichtung mit:

   - einem ersten Kontakt (2a) aus einem ersten Material, der auf der Höhe seines ersten Endes (7a) an einem Träger (8) verankert ist,
   - einem zweiten Kontakt (2b) aus einem zweiten Material, der auf der Höhe seines ersten Endes (7b) an diesem Träger (8) verankert ist,
   - einem elektrischen Verbindungselement (3), das mit einer ersten bzw. zweiten Kontaktfläche (9a, 9b) versehen ist, die in elektrischem Kontakt mit dem ersten Kontakt (2a) und dem zweiten Kontakt (2b) derart stehen, dass ein Thermoelement (1a) gebildet wird,
   - Einrichtungen zur Änderung der Position der ersten und zweiten Kontaktfläche (9a, 9b) auf der Höhe des ersten und zweiten Kontakts (2a, 2b),

   wobei die Vorrichtung **dadurch gekennzeichnet ist, dass** die Einrichtungen zur Änderung der Position der Kontaktflächen (9a, 9b) das elektrische Verbindungselement (3) aufweisen, wobei das Verbindungselement (3) entlang des ersten und zweiten Kontakts (2a, 2b) beweglich ist.

**2.** Vorrichtung gemäß Anspruch 1, **dadurch gekennzeichnet, dass** das bewegliche Verbindungselement (3) von einer Membran (10) getragen wird, deren Verformung ein Verschieben des Verbindungselements (3) entlang des ersten und zweiten Kontakts (2a, 2b) ermöglicht.

**3.** Vorrichtung gemäß Anspruch 2, **dadurch gekennzeichnet, dass** das Verbindungselement (3) Einrichtungen zur Änderung seiner Dicke in einer Richtung senkrecht zu seiner Verschiebungsrichtung umfasst, die in einer Ebene parallel zur Ebene des ersten und zweiten Kontakts (2a, 2b) liegt.

**4.** Vorrichtung gemäß Anspruch 3, **dadurch gekennzeichnet, dass** die Einrichtungen zur Änderung der Dicke des Verbindungselements (3) ein Material (12) aufweisen, das zur Volumenänderung unter Einwirkung einer Erregung geeignet ist.

**5.** Verfahren zur Herstellung einer thermoelektrischen Vorrichtung mit den folgenden Schritten:

- Bilden eines Trägersubstrats (101) mit zwei Kontakten (108a, 108b) aus einem thermoelektrischen Material, die gegeneinander elektrisch isoliert sind,

wobei das Verfahren **dadurch gekennzeichnet ist, dass** es ein bewegliches Element (113) bildet, das die zwei Kontakte elektrisch verbindet und in der Lage ist, sich in einer Richtung senkrecht zu dem Substrat (101) zu verschieben.

**6.** Verfahren gemäß Anspruch 5, **dadurch gekennzeichnet, dass** nach der Ausbildung der Kontakte (108a, 108b) eine Verkapselungsschicht (110) zur Bildung einer Form aufbringt, die zumindest teilweise das bewegliche Element (113) begrenzt.

**7.** Verfahren gemäß einem der Ansprüche 5 und 6, **dadurch gekennzeichnet, dass** die Kontakte durch die folgenden Schritte gebildet werden:

- Aufbringen einer Schicht aus thermoelektrischem Material (103),
- Ausbilden eines Ätzmusters, das eine Längsrichtung aufweist und zwei Bereiche (107a, 107b) umfasst, die durch einen mittigen Abschnitt (107c) verbunden sind, wobei die Quer- und Längsabmessungen der Bereiche (107a, 107b) größer sind als die Querabmessung des mittigen Abschnitts (107c),
- Ätzen der Schicht aus thermoelektrischem Material (103) mithilfe eines Ätzmusters,
- Teilweises Ätzen auf isotrope Weise der Schicht aus thermoelektrischem Material (103), um die Kontakte (108a, 108b) freizulegen.

**8.** Verfahren gemäß den Ansprüchen 6 und 7, **dadurch gekennzeichnet, dass** das Ätzmuster durch eine erste untere Opferschicht (104) und eine zweite obere Opferschicht (106) gebildet wird, wobei die Verkapselungsschicht (110) eine ebene Oberfläche gemeinsam mit der zweiten Opferschicht (106) bildet, und der Hohlraum (111) durch Beseitigung des Ätzmusters auf der Höhe des mittigen Abschnitts (107c) bis zu der Verkapselungsschicht (110) und durch Schrumpfen eines Teils der Verkapselungsschicht zumindest unter einen Teil des mittigen Abschnitts (107c) gebildet ist.

**Claims**

**1.** A thermoelectric device comprising:

- a first leg (2a) made from a first material, anchored at the level of its first end (7a) to a support (8),
- a second leg (2b) made from a second material, anchored at the level of its first end (7b) to said support (8),
- an electric connecting element (3) provided with first and second contact areas (9a, 9b) respectively in electric contact with the first leg (2a) and the second leg (2b) so as to form a thermocouple (1a),
- means for varying the position of the first and second contact areas (9a, 9b) at the level of the first and second legs (2a, 2b),

a device **characterized in that** the means for varying the position of the contact areas (9a, 9b) comprise the electric connecting element (3), said connecting element (3) being movable along said first and second legs (2a, 2b).

**2.** The device according to claim 1, **characterized in that** the movable connecting element (3) is supported by a membrane (10), deformation of which membrane enables sliding of the connecting element (3) along the first and second legs (2a, 2b).

**3.** The device according to claim 2, **characterized in that** the connecting element (3) comprises means to vary its thickness in a direction perpendicular to its direction of sliding and situated in a plane parallel to the plane of the first and second legs (2a, 2b).

**4.** The device according to claim 3, **characterized in that** the means for varying the thickness of the connecting element (3) comprise a material (12) able to change volume by the action of a stimulation.

**5.** A fabrication method of a thermoelectric device comprising a step of forming of two legs (108a, 108b) made from thermoelectric material, electrically insulated from one another, on a support substrate (101),
A method **characterized in that** it comprises a forming of a movable element (113) electrically connecting the two legs and being able to move in a direction perpendicular to the substrate (101).

**6.** The method according to claim 5, **characterized in that** after formation of the legs (108a, 108b), a packaging layer (110) is deposited to form a mould at least partially delineating the movable element (113).

**7.** The method according to one of claims 5 and 6, **characterized in that** the legs are formed by the following steps:

- depositing a layer of thermoelectric material (103),
- forming an etching pattern having a longitudinal direction and comprising two areas (107a, 107b) joined by a central portion (107c), the transverse and longitudinal dimensions of the areas (107a, 107b) being greater than the transverse dimensional of the central portion (107c),
- etching the thermoelectric material layer (103) by means of the etching pattern,
- partially etching the thermoelectric material layer (103) in isotropic manner to release the legs (108a, 108b).

**8.** The method according to claims 6 and 7, **characterized in that** the etching pattern being formed by a bottom first sacrificial layer (104) and a top second sacrificial layer (106), the packaging layer (110) forms a common flat surface with the second sacrificial layer (106), and the cavity (111) is formed by elimination of the etching pattern at the level of the central portion (107c) up to the packaging layer (110), and by removal of part of the packaging layer at least underneath a part of the central portion (107c).

Figure 1 (Art Antérieur)

Figure 2

Figure 3

Figure 4

Figure 5

Figure 6

Figure 7

Figure 8

13a — 13b

3

3'

3''

9a

9b

2b

$L_{Seeb}$

2a

7a

7b

8

Y

Z

X

Figure 9

3

3'

3''

9a

9b

2a

2b

7a

$L_P$

7b

Y

Z

X

Figure 10

Figure 11

Figure 12

Figure 13

Figure 14

Figure 15

Figure 16

Figure 17

Figure 18

Figure 19

Figure 20

Figure 21

Figure 22

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP 2008288535 A